# EUROPEAN PATENT SPECIFICATION

(11) **EP 1 231 594 B1**
(45) Date of publication and mention of the grant of the patent: **24.03.2010**
(21) Application number: 02002249.7
(22) Date of filing: 30.01.2002
(51) Int. Cl.: G09G 3/36, G11C 19/28

(54) **Shift register and liquid crystal display using the same**
Schieberegister und dessen Verwendung in eine Flüssigkristallanzeige
Registre à décalage et son application aux un afficheur à cristaux liquides

(30) Priority: 13.02.2001 KR 2001007068
(43) Date of publication of application: 14.08.2002
(73) Proprietor: SAMSUNG ELECTRONICS CO., LTD., Suwon-si, Gyeonggi-do (KR)
(72) Inventor: Jeon, Jin, Dongan-gu, Anyang-si, Gyeonggi-do (KR)
(74) Representative: Weitzel, Wolfgang

(56) References cited:
- EP-A- 0 315 362
- EP-A1- 0 730 258
- US-A- 4 447 812
- US-A- 5 426 447
- US-A- 6 052 426
- US-A- 6 166 715

## Description

### BACKGROUND OF THE INVENTION

### 1. Field of the Invention

The present invention relates to a shift register of a display device and a liquid crystal display (LCD) using the same, and more particularly, to a shift register generating a scanning signal for scanning gate lines in a gate line driving circuit of AMTFT-LCD (Active Matrix Thin Film Transistor Liquid Crystal Display) and for selecting a block of data lines in a data line block driving circuit.

### 2. Description of the Related Art

In these days, information processing devices have been rapidly developed in a trend with various architectures, functions and faster information processing speed. Information processed in these information processing devices has an electrical signal format. In order to visually confirm information processed in the information processing device, a display for a role as an interface should be provided.

LCDs have advantages such as the lighter weight, small size, high resolution, lower power consumption and friendly relation with environment and they render display of full colors compared with the traditional cathode ray tube (CRT). Such the advantages allow the LCDs to replace the CRTs and to be spotlighted as a next generation display.

LCDs apply an electric power to liquid crystal having a specific molecular configuration to vary the molecular arrangement of liquid crystal. The variation in the molecular configuration of liquid crystal causes a variation in optical properties such as birefringence, optical rotary power, dichroism and light scattering. The LCDs utilize such variations in optical properties to display an image.

The LCD device is largely sorted into a TN (Twisted Nematic) type and a STN (Super-Twisted Nematic) type. The liquid crystal display device is, according to the driving method, sorted into an active matrix display type, which uses a switching device and a TN liquid crystal, and a passive matrix type, which uses an STN liquid crystal.

A distinguishable difference of two types is in that the active matrix display type is applied to a TFT-LCD that drives the LCD by using a TFT and the passive matrix display type dispenses with a complicated circuit associated with a transistor because of using no transistor

TFT-LCD is divided into amorphous silicon TFT LCD (a-Si TFT-LCD) and polycrystalline silicon TFT LCD (poly-Si TFT-LCD). Poly-Si TFT-LCD has advantages of lower power consumption, lower price compared with a-Si TFT-LCD but has a drawback in that its manufacturing process is complicated. Thus, poly-Si TFT-LCD is mainly used in a small sized display such as mobile phones.

Amorphous-Si TFT-LCD is applied to a large screen sized display such as notebook personal computer (PC), LCD monitor, high definition (HD) television, etc., due to easy application of large screen and high production yield.

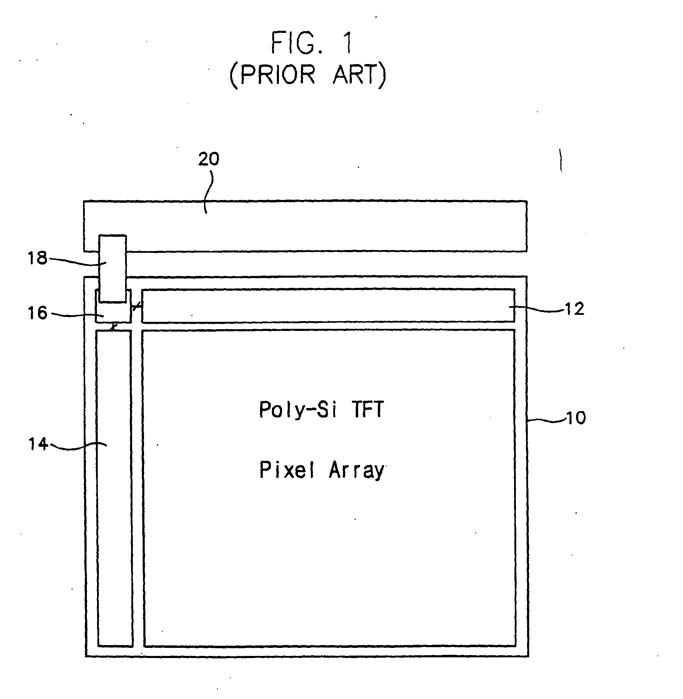

As shown in FIG. 1, poly-Si TFT LCD includes a data driving circuit 12 and a gate driving circuit 14 that are formed on a glass substrate 10 having a pixel array. A terminal part 16 is connected with an integrated printed circuit board (PCB) 20 using a film cable 18. This structure saves the manufacturing costs and minimizes the power loss due to the integration of driving circuits.

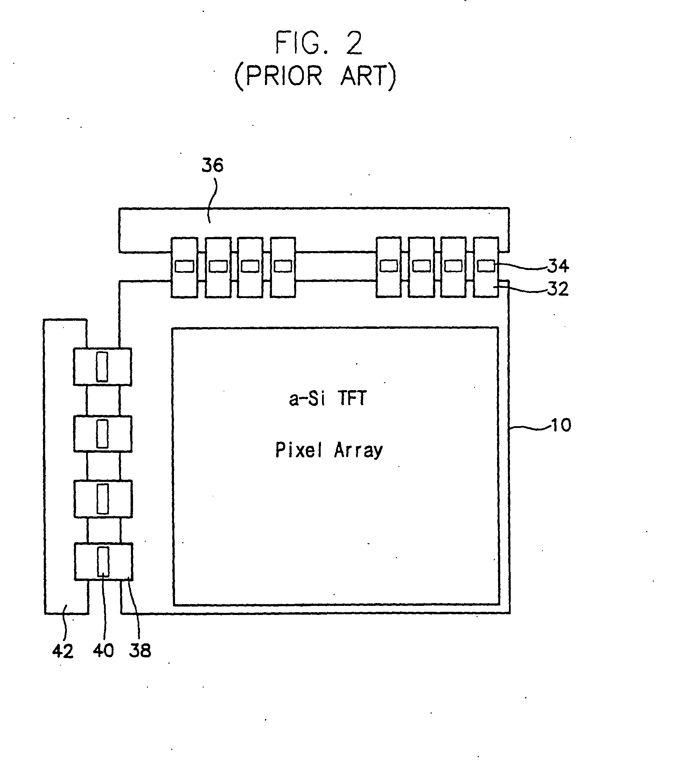

As shown in FIG. 2, amorphous-Si TFT LCD has a data driving chip 34 formed on a flexible printed circuit board 32 in a manner of COF (Chip-On-Film). A data printed circuit board 36 is connected with a data line terminal of the pixel array through the flexible PCB 32. A gate driving chip 40 is formed on a flexible PCB 38 in a manner of COF. A gate PCB 42 is connected with a gate line terminal through the flexible PCB 40.

Recently, there is also disclosed a technique for removing the gate PCB from the LCD by employing an integrated PCB technique mounting a gate power supply part on the data PCB. Korean Patent Laid-Open Publication No. 2000-66493 previously filed by the present assignee discloses an LCD module employing an integrated PCB by which the gate PCB is removed.

However, although the integrated PCB is employed, the flexible PCB having the flexible PCB is still used. Thus, since plural flexible PCBs should be assembled in a glass substrate, a fabrication process of a-Si TFT LCD, especially OLB (Outer Lead Bonding) process becomes complicated compared with that of poly-Si TFT LCD, whereby its fabrication costs becomes higher.

Thus, there are many endeavors for decreasing the number of the assembly process by simultaneously forming data driving circuit and gate driving circuit along with pixel array on a glass substrate in a-Si TFT LCD like poly-Si TFT LCD.

US Patent No. 5,517,542 discloses a technique for an a-Si TFT gate driving circuit formed on a glass substrate.

In the above US patent No. 5,517,542, a shift register of the gate driving circuit uses three clock signals. Each stage of the shift register two clock signals of three clock signals, is enabled with an output signal of previous stage as an input signal, and maintains the disable state by feeding back an output of the second next stage.

Each stage in the US Patent provides a voltage applied to gate of full-down transistor in a capacitor charge manner in order to maintain the disable status. Thus, when an increase in gate threshold voltage of the full-down transistor due to stress of the full-down transistor is elevated higher than the charge voltage of the capacitor, there may occur a turn-off of the full-down transistor in the disable status.

The above US patent employs a power supply circuit elevating a VDD in proportional to the increase in the threshold voltage of the a-Si TFT LCD in order to prevent an error operation due to the increase in the threshold voltage.

From the US 4 447 812 an LCD module with a standard shift register is known. Another state-of-the-art shift register is disclosed in the US 6, 052, 426 in which two clock signals are applied to each of the stages. This results in a complicated wiring scheme.

### SUMMARY OF THE INVENTION

Accordingly, it is an object of the present invention to provide a shift register in accordance with that claimed in independent claim 1.

Preferably, each stage further comprises a turn-on preventing means connected to the input node of the pull-down means, wherein the turn-on preventing means connects the first power voltage to the input node of the pull-down means in response to the output signal of the output terminal to prevent the pull-down means from being turned on.

The turn on preventing means comprises an NMOS transistor of which drain is connected to the input node of the pull-down means, gate is connected to the output terminal and source is connected to the first power voltage.

Also, the pull-up driving means has a capacitor connected between the input node of the pull-up means and the output terminal; a first transistor of which drain and gate are commonly connected to the input terminal and source is connected to the input node of the pull-up means; a second transistor of which drain is connected to the input node of the pull-up means, gate is connected to the input node of the pull-down means and source is connected to the first power voltage; and a third transistor of which drain is connected to the input node of the pull-up means, gate is connected to an output signal of a next stage and source is connected to the first power voltage.

The pull-down driving means comprises: a fourth transistor of which drain is connected to the second power voltage, gate is connected to the output signal of the next stage and source is connected to the input node of the pull-down means; and a fifth transistor of which drain is connected to the input node of the pull-down means, gate is connected to the input signal and source is connected to the first power voltage.

The floating preventing means has a sixth transistor of which drain and gate are connected to the second power voltage and source is connected to the input node of the pull-down means, wherein the sixth transistor has a size smaller sufficiently than the fifth transistor. Here, it is preferable that a size ratio of the fifth transistor to the sixth transistor is approximately 20:1.

By the above constitution, it is desirable that the external connection terminal connected to the shift register comprises five terminals of a first clock signal input terminal, a second clock signal input terminal, a start signal input terminal, a first power voltage input terminal and a second power voltage input terminal.

Also, it is desirable that a size ratio of the fifth transistor to the seventh transistor is approximately 2:1.

To accomplish the second and third objects of the present invention, there is an LCD comprising a display cell array circuit, a data driving circuit and a gate driving circuit formed on a transparent substrate.

The display cell array circuit has plural data lines and plural gate lines, each of the display cell arrays connected to a corresponding pair of data line and gate line.

The gate driving circuit has a first shift register comprising plural stages connected one after another to each other, the plural stages having a first stage in which a start signal is coupled to an input terminal, for sequentially selecting the plural gate lines using an output signal of each stage.

The data driving circuit comprising plural data line blocks and a second shift register, each of the data line blocks comprising plural driving transistors each of which drain and source are connected between a data input terminal and the data line and gate is commonly connected to a block selection terminal, the second shift register comprising plural stages connected one after another to each other, the plural stages having a first stage in which a data block selection start signal is coupled to an input terminal, for sequentially selecting the plural data line blocks using an output signal of each stage.

The LCD further comprises a flexible PCB on which an integral control and data driving chip is mounted, for providing the input terminals of the gate and data driving circuits with a control signal and a data signal.

The first and second shift registers employ the shift register for accomplishing the first object of the present.

It is desirable that a duty period of the first and second clock signals applied to the first shift register is greater than a period of a duty period of the first and second clock signals applied to the second shift register multiplied by a number of the data line blocks.

The transparent substrate is connected to the flexible PCB through an external connection terminal. The external connection terminal has; five terminals connected to the data driving circuit of a first clock signal input terminal, second clock signal input terminal, scan start signal input terminal, first power voltage input terminal and second power voltage input terminal; and three control terminals of first clock signal input terminal, second clock signal input terminal and block selection start signal input terminal; and plural data input terminals all of which are connected to the data driving circuit.

### BRIEF DESCRIPTION OF THE DRAWINGS

The above objects and other advantages of the present invention will become more apparently by describing in detail the preferred embodiments thereof with reference to the accompanying drawings, in which:
FIG. 1 is a simplified schematic view showing a TFT substrate in a poly-TFT LCD in accordance with the conventional art;
FIG. 2 is a simplified schematic view showing a TFT substrate in an amorphous-TFT LCD in accordance with the conventional art;
FIG. 3 is a disassembled perspective view of an amorphous-Si TFT LCD in accordance with a preferred embodiment of the present invention;
FIG. 4 is a schematic view showing the TFT substrate in an amorphous-Si TFT LCD in accordance with a preferred embodiment of the present invention;
FIG. 5 is a block diagram of a shift register in the data driving circuit of FIG. 4;
FIG. 6 is a block diagram of a shift register in the gate driving circuit of FIG. 4;
FIG. 7 is a detailed circuit diagram of each stage in the shift registers of FIGS. 5 and 6;
FIG. 8 is a timing diagram of respective elements of FIG. 7;
FIG. 9 is an output waveform simulated at respective stage of FIG. 7;
FIG. 10 is a simulated waveform of a delay characteristic for the clock signal of the output signals in FIG. 7;
FIG. 11 is a layout of an external connection terminal in the gate driving circuit of the present invention;
FIGS. 12 through 14 are comparative waveforms comparing the shift register of the present invention with that of the conventional art;
FIG. 15 is a schematic view illustrating a panel in which the entire channels are simultaneously driven;
FIG. 16 is a schematic view of a panel driven in a block driving manner in accordance with the present invention;
FIG. 17 is a timing chart of respective elements in the block driving manner of the present invention; and
FIGS. 18 through 20 are views showing simulated results of gate line driving signal, data line block selection signal and pixel charge characteristic in which a switching transistor (SWT) is designed to have a width of 4,000 µm and a length of 5 µs.

### DETAILED DESCRIPTION OF THE PREFERRED EMBODIMENTS

Reference will now be made in detail to the preferred embodiments of the present invention, examples of which are illustrated in the accompanying drawings. Hereinafter, preferred embodiments are described with reference to the accompanying drawings.

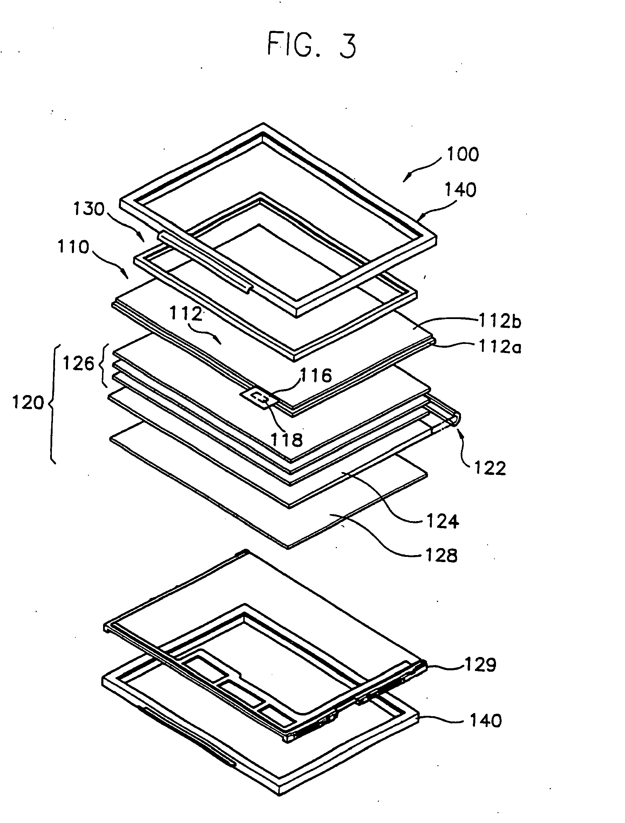

FIG. 3 is a disassembled perspective view of an a-si TFT LCD in accordance with the present invention.

Referring to FIG. 3, an LCD 100 includes an LCD panel assembly 110, a backlight assembly 120, a chassis 130 and a cover 140.

The LCD assembly 110 includes an LCD panel 112, a flexible PCB 116 and an integral control and data driving chip 118. The LCD panel 112 includes a TFT substrate 112a and a color filter substrate 112b. On the TFT substrate 112a, there are disposed a display cell array circuit, a data driving circuit, a gate driving circuit and external connection terminal. The TFT substrate 112a faces with the color filter substrate 112b. Liquid crystal is injected between the TFT substrate 112a and the color filter substrate 112b, and an injection inlet of liquid crystal is then sealed.

The integral control and data driving chip 118 mounted on the flexible PCB 116 is connected with circuits formed on the TFT substrate 112a through the flexible PCB 116. The flexible PCB 116 provides the data driving circuit and the gate driving circuit of the TFT substrate 112a with data signals, data timing signals, gate timing signals and gate driving voltages.

The backlight assembly 120 includes a lamp assembly 122, a light guiding plate 124, a series of optical sheets 126, a reflector plate 128 and a mold frame 129.

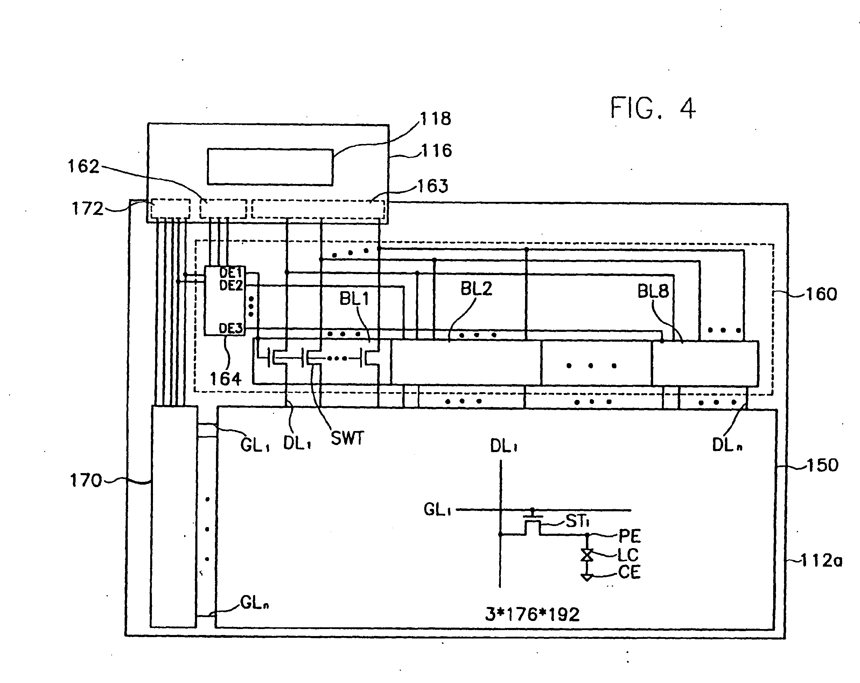

Referring to FIG. 4, on the TFT substrate 112a of the present invention, there are arranged a display cell array circuit 150, a data driving circuit 160, a gate driving circuit 170, an external connection terminal 162 and 163 for the data driving circuit 170, which are formed during the formation of TFTs.

The display cell array circuit 150 includes an m-number of data lines DL1-DLm extended along the column direction and an n-number of gate lines GL1-GLn extended along the row direction.

In one embodiment of the present embodiment, there is provided an example of 2 inches-LCD panel having a resolution of 525(176×3) ×192 corresponding to numbers of the gate lines and data lines.

Switching transistors ST are formed at the cross points of the data lines and the data lines. Switching transistor STi has a drain connected to a data line DLi and a gate connected to a gate line GLi. Source of the switching transistor STi is connected to a transparent pixel electrode PE. Liquid crystal LC is arranged between the transparent pixel electrode PE and a transparent common electrode CE.

Thus, a voltage applied between the transparent pixel electrode PE and the transparent common electrode CE controls the alignment of liquid crystal molecules, thus light amount passing through the liquid crystal molecules is controlled and thereby gray scales for respective pixels are displayed.

The data driving circuit 160 includes a shift register 164 and 568 switching transistors SWT. The 528 switching transistors SWT form eight data line blocks BL1-BL8 per sixty-six switching transistors.

In any data line block BLi, sixty-six input terminals are commonly connected to an external input terminal 163 consisting of sixty-six data input terminals and sixty-six output terminals are connected to the corresponding sixty-six data lines. Also, a block selection terminal is connected to a corresponding one output terminal of eight output terminals of the shift register 164.

The 528 switching transistors SWT is made of a-Si TFT MOS transistor of which source is connected to corresponding data line, drain is connected to a corresponding input terminal among 66 number of data input terminals, and gate is connected to block selection terminal.

Accordingly, 528 data lines are divided into eight blocks each having sixty-six data lines and the eight blocks are each selected sequentially by eight block selection signals.

The shift register 164 receives a first clock signal ("CKH"), a second clock signal ("CKHB") and a block selection start signal ("STH"). The output terminals of the shift register 164 are connected to the block selection terminals of corresponding lines blocks.

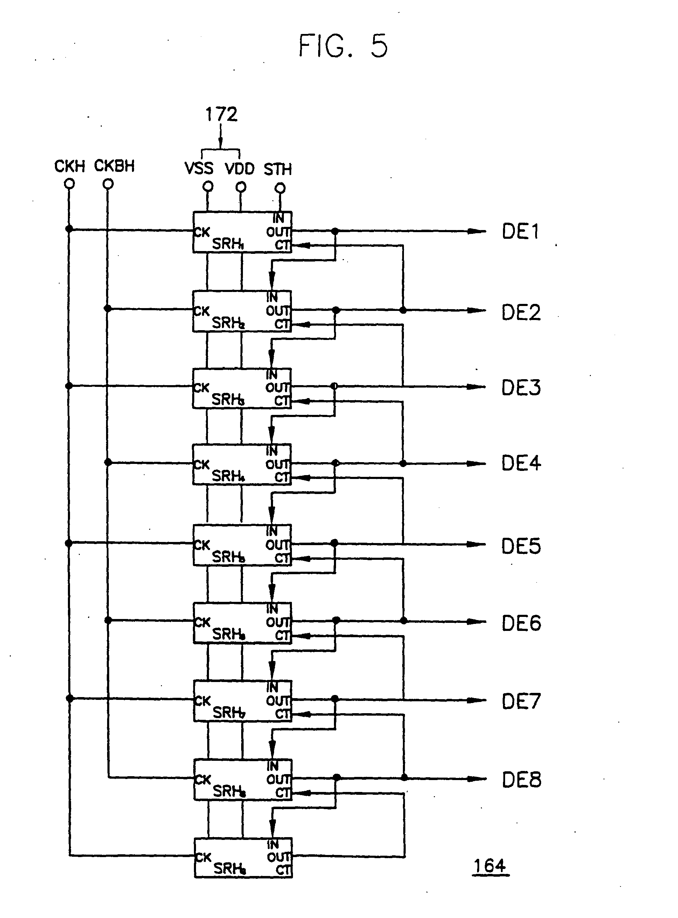

Referring to FIG. 5, the shift register 164 includes nine stages SRH1 to SRH9 subordinated to one after another. In other words, the output terminal "OUT" of each stage is connected to the input terminal "IN" of the next stage. The nine stages have eight stages SRH1 to SRH8 corresponding to data line blocks and one dummy stage SRH9. Each stage has input terminal IN, output terminal OUT, control terminal "CT", clock signal input terminal "CK", first power voltage terminal "VSS" and second power voltage terminal "VDD". The eight stages SRH1 to SRH8 provide the block selection terminals of respective data line blocks BL1 to BL8 with the block selection start signals DE1 to DE8, respectively. The block selection start signals are the enable signals for respective line blocks.

Odd stages SRH1, SRH3, SRH5, SRH7, SrH9 receive the first clock signal "CKH" and even stages SRC2, SRC4, SRH6, SRH8 receive the second clock signal. The first clock signal CKH and the second clock signal CKHB have a phase opposite to each other. Duty periods of the first and second clock signals CKH and CKHB are set to be less than 1/66ms.

The output signal of the next stage to a present stage is input to the control terminal CT of the present stage as a control signal. In other words, the control signal that is input to the control terminal CT is delayed by the duty period of the output signal itself.

Thus, since the output signals of respective stages are sequentially generated with active period of high state, data line blocks corresponding to active periods of respective output signals are selected and become enable.

Dummy stage SRH9 is used for providing the control terminal CT of the previous stage SRH8 with a control signal.

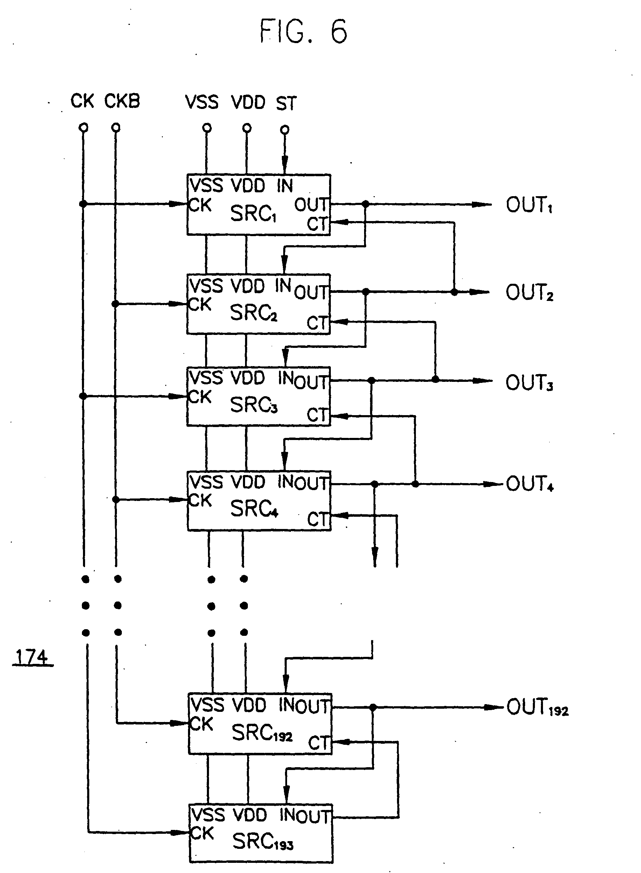

Referring to FIG. 6, the gate driving circuit 170 has a single shift register. The shift register 174 of FIG. 6 includes plural stages SRC1 to SRC4 subordinated to one after another. In other words, the output terminal "OUT' of each stage is connected to the input terminal IN of the next stage. The stages consist of 192 stages SRC1 to SRC192 corresponding to gate lines and one dummy stage SRC193. Each stage has input terminal IN, output terminal OUT, control terminal CT, clock signal input terminal CK, first power voltage terminal VSS and second power voltage terminal VDD.

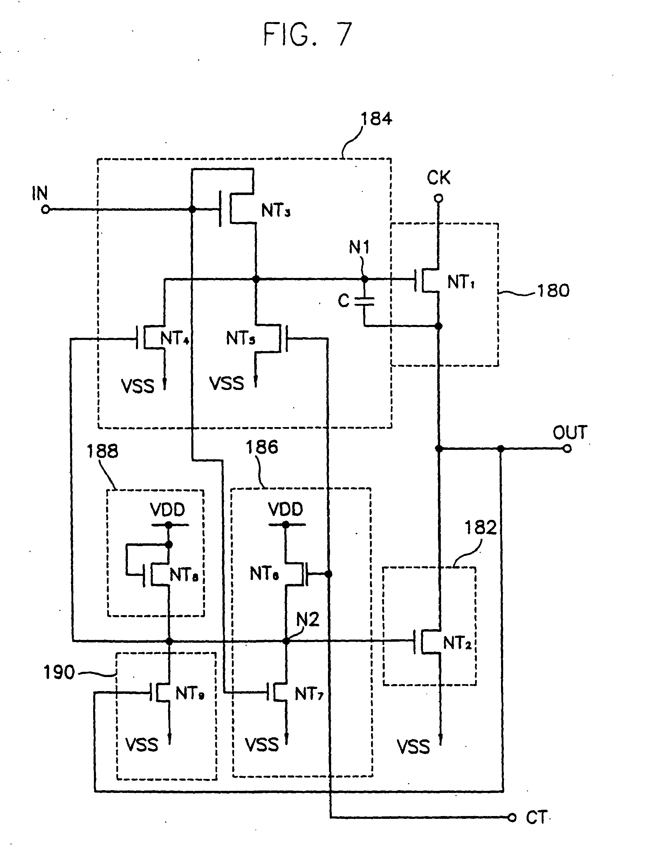

To the input terminal "IN" of the first stage is input a start signal "ST' as shown in FIG. 7. Here, the start signal is a pulse signal synchronized with a vertical synchronous signal.

Output terminals OUT1 to OUT192 of respective stages are connected to respective corresponding gate lines. To odd stages SRC1 and SRC3 is supplied the first clock signal CK and to even stages SRC2 and SRC4 is supplied the second clock signal CKB. The first clock signal CK has an opposite phase to the second clock signal CKB. The first and second clock signals CK and CKB have a duty period of 16.6/192ms.

Thus, compared with the duty period of the clock signal of the shift register 164 for the data driving circuit, the duty period of the clock signal of the shift register 170 for the gate driving circuit is 8 times and more.

The output signals OUT2, OUT3 and OUT4 of the next stages SRC2, SRC3 and SRC 4 to present stages SRC1, SRC2 and SRC3 are input to the control terminal CT of the present stages SRC1, SRC2 and SRC3 as a control signal. In other words, the control signal that is input to the control terminal CT is delayed by the duty period of the output signal itself.

Thus, since the output signals of respective stages are sequentially generated with active period of high state, horizontal lines corresponding to active periods of respective output signals are selected.

Hereinafter, there is described a concrete circuit constitution of each stage of the shift registers in the aforementioned data driving circuit and gate driving circuit with reference to FIG. 7.

Referring to FIG. 7, each stage of the shift registers 164 and 174 includes pull-up section 180, pull-down section 182, pull-up driving section 184, pull-down driving section 186, floating preventing section 188 and turn-on preventing section 190.

The pull-up section 180 includes a pull-up NMOS transistor NT1 of which drain is connected to a clock signal input terminal CK, gate is connected to a first node N1 and source is connected to an output terminal OUT.

The pull-down section 182 includes a pull-down NMOS transistor NT2 of which drain is connected to an output terminal OUT, gate is connected to a second node N2 and source is connected to a first power voltage VSS.

The pull-up driving section 184 includes a capacitor C and an NMOS transistor NT3 to NT5. The capacitor C is connected between the first node N1 and the output terminal OUT. Transistor NT3 has a drain and gate commonly connected to the input terminal IN and a source connected to the first node "N1". Transistor NT4 has a drain connected to the first node N1, a gate connected to the second node "N2: and a source connected to the first power voltage VSS. Transistor NT5 has a drain connected to the first node N1, a gate connected to the control terminal "CT' and a source connected to the first power voltage VSS.

The pull-down driving section 186 includes two NMOS transistors NT6 and NT7. Transistor NT6 has a drain connected to the second power voltage VDD, a gate connected to the control terminal CT and a source connected to the second node "N2". Transistor NT7 has a drain connected to the second node "N2", a gate connected to the input terminal "IN" and a source connected to the first power voltage VSS.

The floating preventing section 188 includes an NMOS transistor NT8 of which drain and gate are commonly connected to the second power voltage VDD and a source is connected to the second node N2. Transistor NT8 has a size smaller sufficiently than transistor NT7, for example, has a size ratio of 1:20.

The turn-on preventing section 190 includes an NMOS transistor NT9 of which drain is connected to the second node N2, gate is connected to the output terminal OUT and source is connected to the first power voltage VSS. Transistor NT9 has a size ratio of 1:2 to transistor NT7.

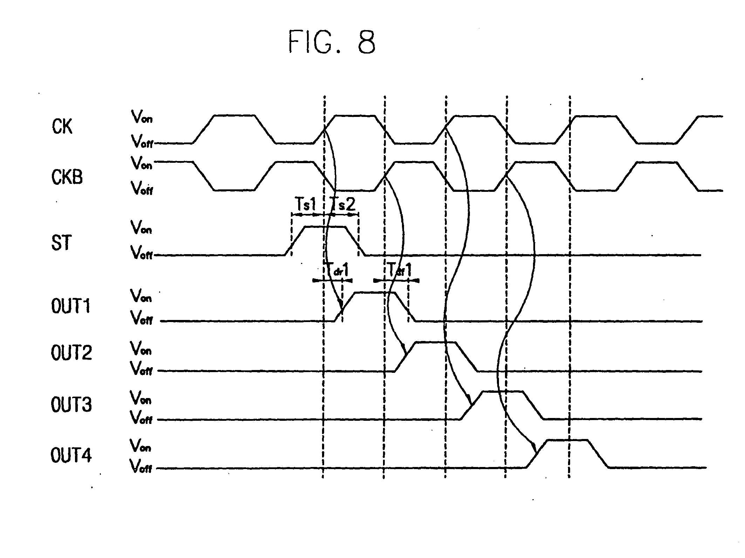

As shown in FIG. 8, as first and second clock signals CK and CKB and scan start signal ST are supplied to the shift register 170, the first stage SRC1 delays a high level period of the first clock signal CK in response to the front edge of the scan start signal ST for a predetermined time of Tdr1 to thereby output a delayed output signal OUT1.

The active period of the scan start signal ST has a phase faster by 1/4 than the high level period of the first clock signal CK. The active period of the scan start signal ST is divided into a set up time Ts1 from a front edge of a pulse, i.e., a rising edge and a hold time Ts2 to a rear edge of a pulse, i.e., a falling edge.

Accordingly, the front edge of the output signal OUT1 has a front edge, i.e., rising edge delayed by a certain time of approximately 2-4 µs from the start point of the hold time Ts2. In other words, active period of the first clock signal CK, i.e., high level period is delay-output by a time of Tdr1 to the output terminal OUT.

This delay characteristic is due to the fact that the capacitor C of the pull-up driving section 184 starts to be charged through the transistor NT3 in a state where the transistor NT4 is turned off at the front edge of the start signal ST and the pull-up transistor NT1 is turned on after the charged voltage of the capacitor C becomes higher than a threshold voltage between the gate and the source of the pull-up transistor NT1, whereby the high level period of the first clock signal CK is generated at the output terminal.

As the high level period of clock signal is generated at the output terminal OUT, this output voltage is bootstrapped at the capacitor C and thereby the gate voltage of the pull-up transistor NT1 rises over the turn-on voltage VDD. Accordingly, the pull-up transistor NT1 of NMOS transistor maintains a full turn-on state.

Meanwhile, in the pull-down driving section 186, since the transistor NT7 is turned on at the front edge of the start signal ST in a state where the transistor NT6 is turned off, a potential of the second node N2 is dropped to the first power voltage VSS. At this time, the transistor NT8 of the floating preventing section 188 maintains the turn on state while since a size of the turn on transistor NT7 is larger 20 times than the transistor NT8, the second node N2 is voltage-dropped to the first power voltage VSS from the second power voltage VDD. Therefore, the pull-down transistor NT2 is transferred from the turn-on state to the turn-off state.

When the turn-on voltage (VON=VDD) is output from the output terminal OUT, the transistor NT9 of the turn on preventing section 190 is turned on, so that a capability for driving the second node N2 using the first power voltage VSS increases approximately 50%. Thus, rising of the second node voltage can be prevented by a parasitic capacitance between drain and source of the pull-down transistor upon the rising transition of the output signal. As a result, an error operation of the pull-down transistor in which the pull-down transistor is turned on upon the rising transition of the output signal may be prevented. At this time, the output signal OUT1 of the output terminal OUT is delay-generated by the duty period of the first clock signal CK.

As a voltage of the output signal of the output terminal OUT is dropped to the turn off voltage state VOFF=VSS, the transistor NT9 is turned off and only the second power voltage VDD is supplied to the second node N2 through the transistor NT8. So, a potential of the second node N2 starts to rise from the first power voltage VSS to the second power voltage VDD. As the potential of the second node N2 rises, the transistor NT4 is turned on and thus a charge voltage of the capacitor is discharged through the transistor NT4. As a result, the pull-up transistor NT1 starts to be turned off.

Continuously, since an output signal of the next stage that is supplied to the control terminal CT rises to the turn-on voltage, the transistors NT5 and NT6 are turned on. Thus, a potential of the second node N2 starts to rise rapidly to the second power voltage VDD that is supplied by the transistors NT6 and NT8 and a potential of the first node N1 is rapidly dropped to the first power voltage VSS through the transistors NT4 and NT5.

Thus, the pull-up transistor NT1 is turned off and the pull-down transistor NT2 is turned on, so that a voltage of the output terminal OUT is dropped from the turn on voltage VON to the turn off voltage VOFF of the second power voltage VDD.

Although an output signal level of the next stage that is applied to the control terminal CT is dropped to a low level and thereby the transistor NT6 is turned off, the second node N2 maintains the second voltage VDD-biased state through the transistor NT8 and the first node N1 maintains the first power voltage VSS-biased state through the transistor NT4 maintaining the turn on state. Thus, although a threshold voltage of the transistors NT2 and NT4 due to the long term use rises, since a potential of the second node N2 is maintained at the second power voltage VDD, a stable operation can be secured without an error operation such as the pull-down transistor NT2 being turned off.

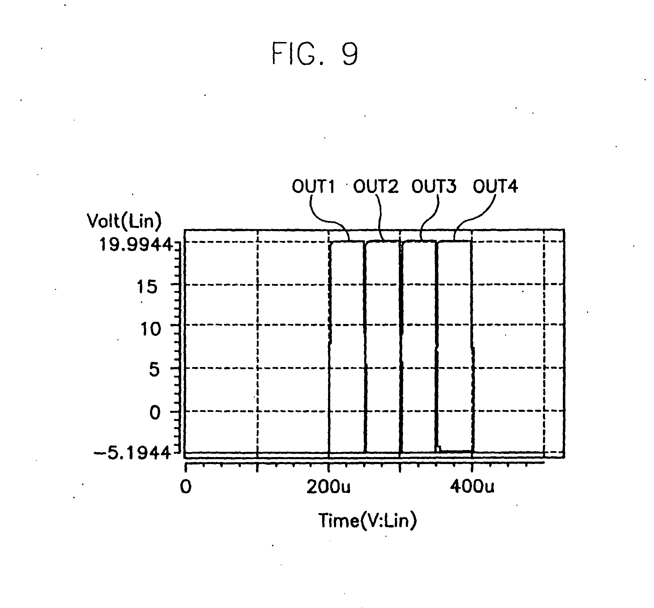

Respective stages SRC1-SRC4 are operated in the same manner with the aforementioned method and thus output signals OUT1 to OUT4 are sequentially and stably generated as shown in FIG. 9.

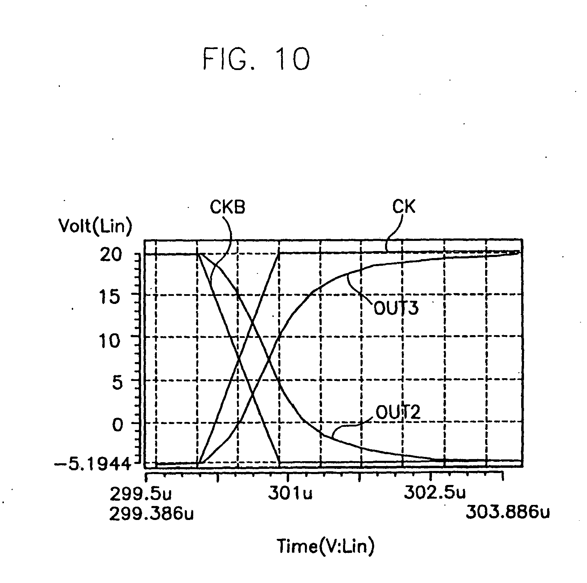

FIG. 10 shows a simulation result of when a gate line load 30pF for a 2 inches panel is connected to the aforementioned shift register of the present invention. As shown in FIG. 10, the result shows that output signals OUT2 and OUT 3 are delayed with respect to the clock signals CK and CKB, respectively. A rising time and a falling time of the output signals are approximately 1.5 µs, a delay rising time Tdr and a delay falling time Tdf of from the clock signal are approximately 0.3 µs.

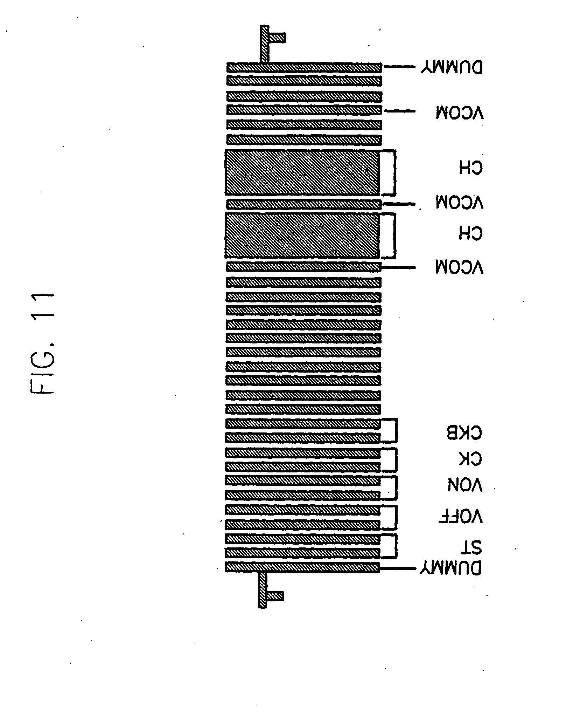

FIG. 11 shows a lay-out of an external connection terminal part that is provided in a shift register of a gate driving circuit integrated on an LCD panel of the present invention. Right side of the lay-out is a TFT side and left side of the lay-out is a film cable side. As shown in FIG. 11, the shift register of the present invention needs only five external connection terminals of a start signal (ST) input terminal, a first clock signal input terminal CK, a second clock signal input terminal CKB, a first power voltage terminal VOFF or VSS and a second power voltage terminal VON or VDD. Accordingly, a space occupied by the terminal part 172 on the glass substrate can be decreased.

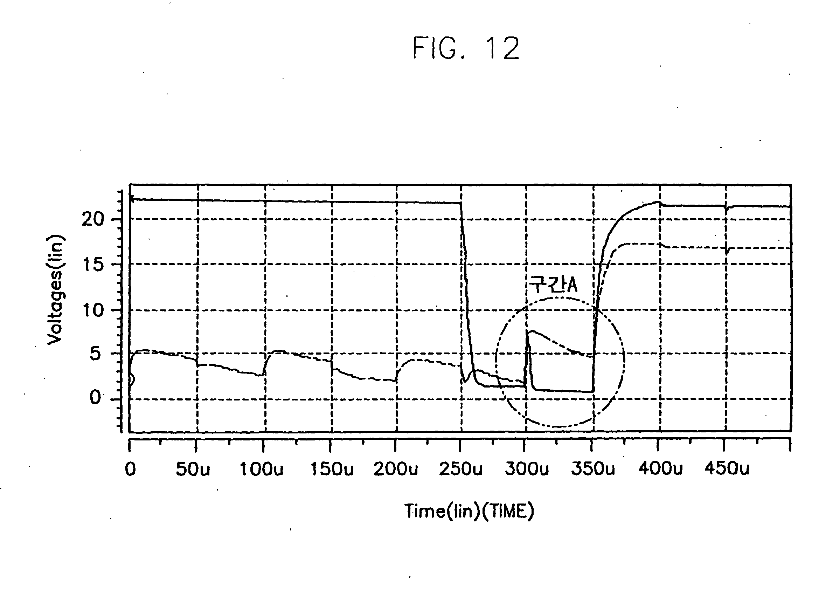

FIGS. 12 to 14 are waveforms comparing an output characteristic of a conventional shift register employing a pull-down control technique using a capacitor with that of a shift register of the present invention.

FIG. 12 is a graph for comparing a voltage waveform of the second node N2. As shown in FIG. 12, the present invention corresponding to the solid line maintains more stable low level state than the conventional art of the dotted line in a sector "A".

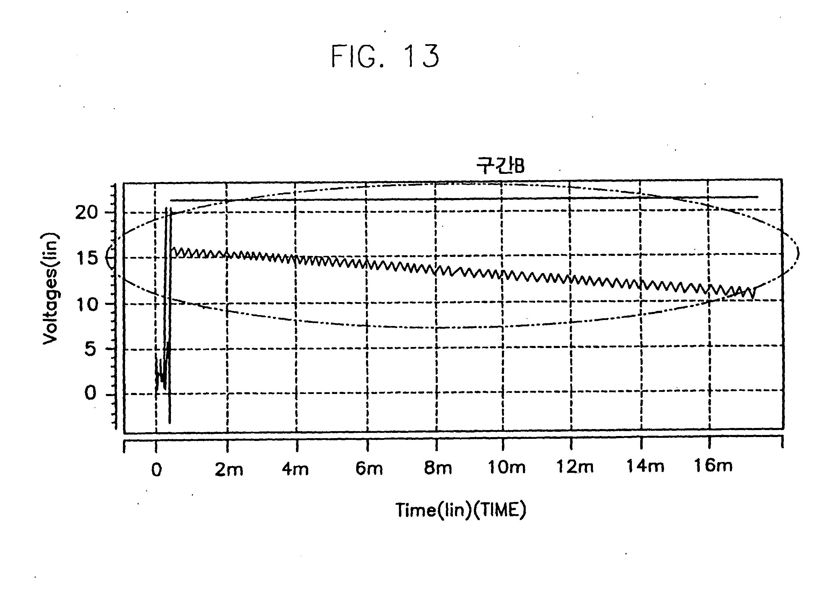

FIG. 13 is a graph for comparing a state variation in the high level of the second node N2. The conventional art of the dotted line shows that the level is decreased according to the time elapse while the present invention of the solid line shows that a constant level is maintained regardless of the time elapse. This is because the present invention always maintains a supply state of the power voltage VDD through the floating preventing section.

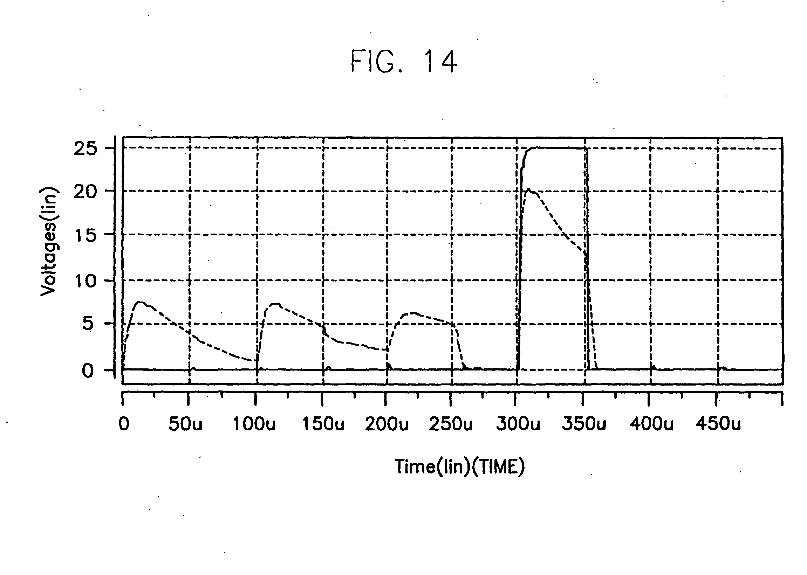

FIG. 14 is a graph for comparing waveforms of output signals in the output terminals. It is shown that an output signal waveform of the solid line corresponding to the present invention maintains more stable high level state in the active state (that is, high level state) compared with an output signal waveform of the broken line corresponding to the conventional art. It is also known that the present invention maintains a stable low level biased state in the non-active state (that is, low level state).

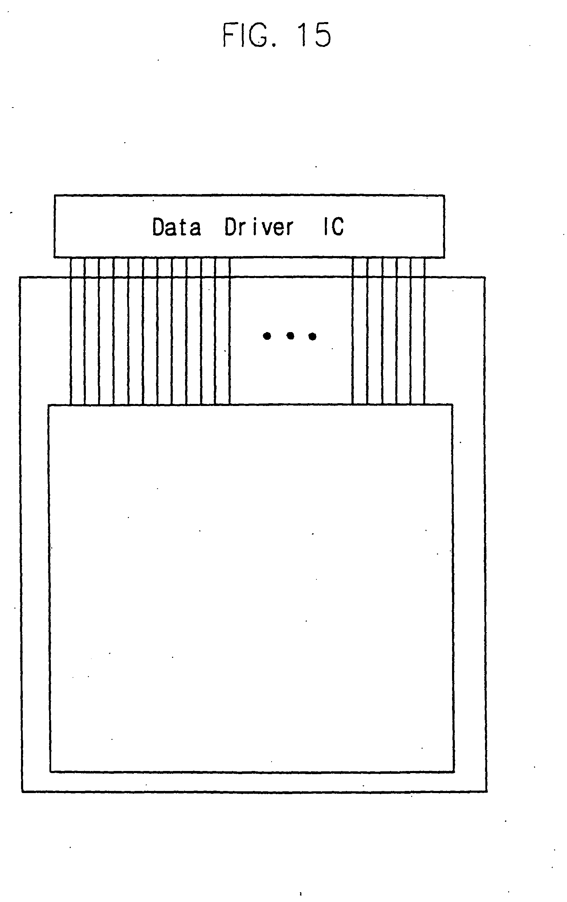

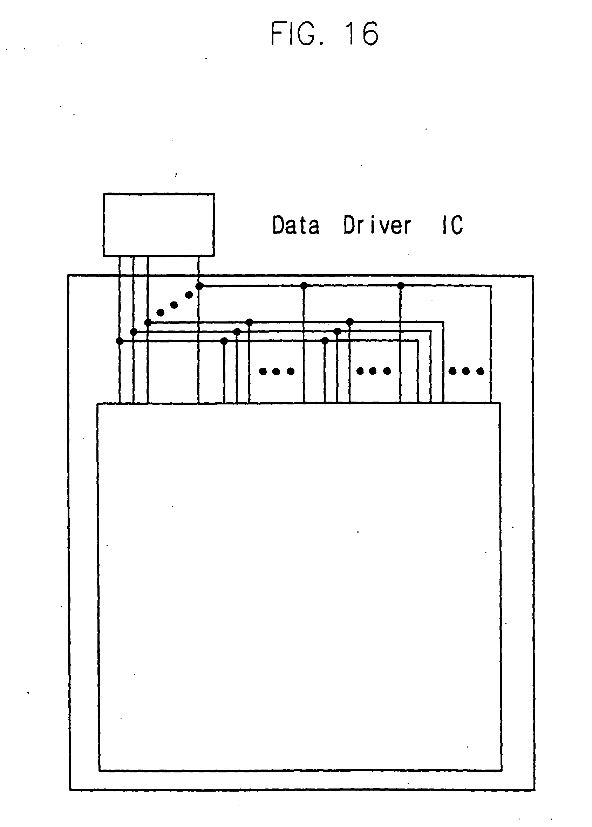

The data driving circuit 160 of the present invention employs not a simultaneous operative manner of whole channels (see FIG. 15) but a block driving manner (see FIG. 16).

It is not easy to accomplish a complicated analog function of a data driving chip using a-Si TFT. However, the block driving using a switching transistor can markedly decrease the number of video channels that are provided to an LCD panel from the data driving chip. The block driving renders the charge time of the pixels to decrease. But, since a small sized panel of 2 inches can have a sufficient line time compared with the monitor for notebook computer or desk top computer, it is possible to employ the block operation.

The charge time of the pixel according to the resolution is shown in the following table 1.

**<TABLE 1>**

| RESOLUTION | 2" (176*192) | XGA (1024*768) | SXGA (1280*1024) | UXGA (1600*1200 |
|---|---|---|---|---|
| CHARGE TIME | 86µs | 20µs | 15µs | 13µs |

In an UXGA level panel, a possible charge time is 7-8µs upon considering a load and a delay depending on the panel size. Accordingly, upon considering a data driving chip having the same driving capability, 2"-sized panel has a charge time ten times or more than an UXGA level panel. Thus, although a block operation dividing the data line into ten blocks is performed, 2"-sized panel has the same charge characteristic with UXGA level panel.

Accordingly, the present invention block-operates the data lines divided into eight blocks in 2" sized panel. Therefore, if 528 video channels are divided into eight blocks, each block is assigned sixty-six channels. Thus, when compared with the simultaneous operation manner of 528 whole channels (see FIG. 15), it is possible to decrease a connection channel number from 528 channels to sixty-six channels.

Thus, the present invention employs the block operation manner of the data lines and integrates on a panel the data line driving circuit that sequentially selects respective blocks using the shift register, thereby markedly decreasing the connection terminal number between the data driving chip and the panel to 1/8.

Accordingly, since embodiments in accordance with the present invention need only total connection terminals of sixty-six channel terminals, three data control terminals, five gate control terminals and one common voltage terminal (VCOM), seventy-five total connection terminals are necessary.

Thus, the present invention can decrease the number of the external connection terminals markedly and the outer track size of the panel, so that the manufacturing cost is saved and the productivity and the price of the goods due to the slimmed panel are enhanced.

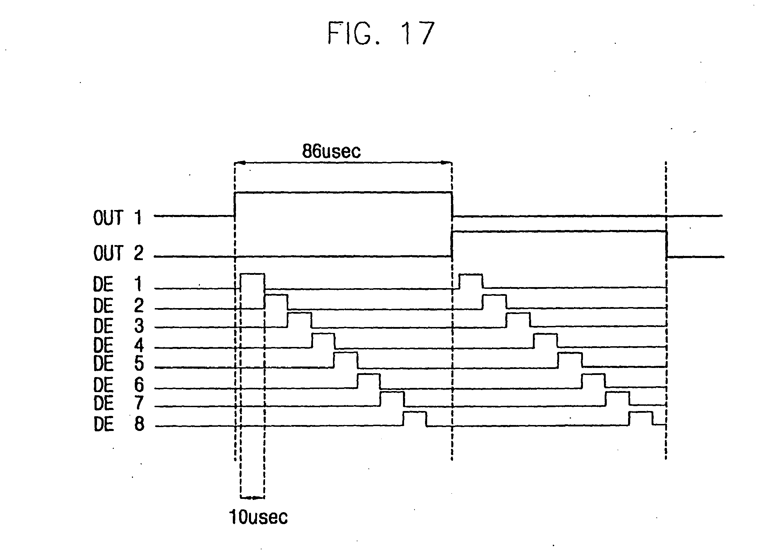

Referring to FIG. 17, the block operation manner generates block selection signals DE1 to DE8 through the shift register 164 in order to sequentially enable 8 blocks at the active section.

The present invention designs a 2" panel having a resolution of 176*192 to have a gate line active period of 86 µs and an active period of 10 µs for each block selection signal. Accordingly, it is possible to maintain a sufficient pixel charge characteristic upon the block operation.

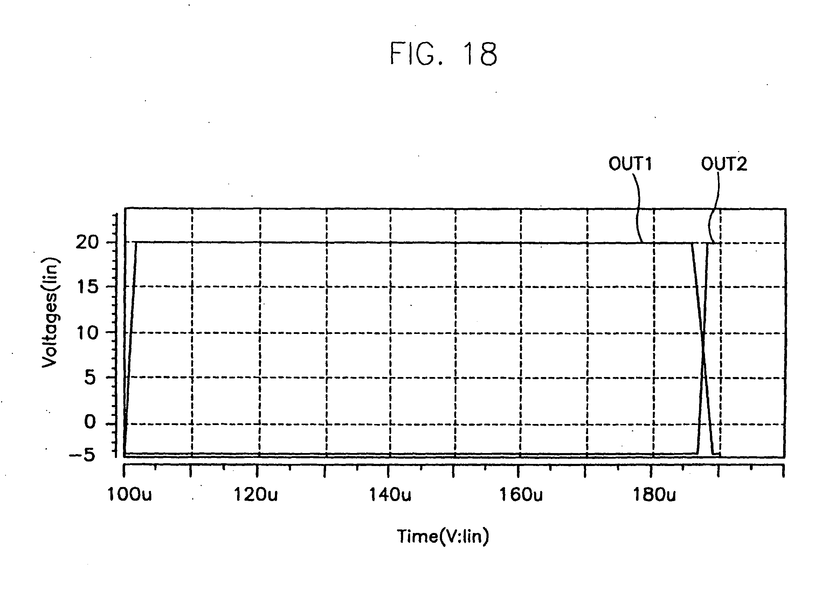

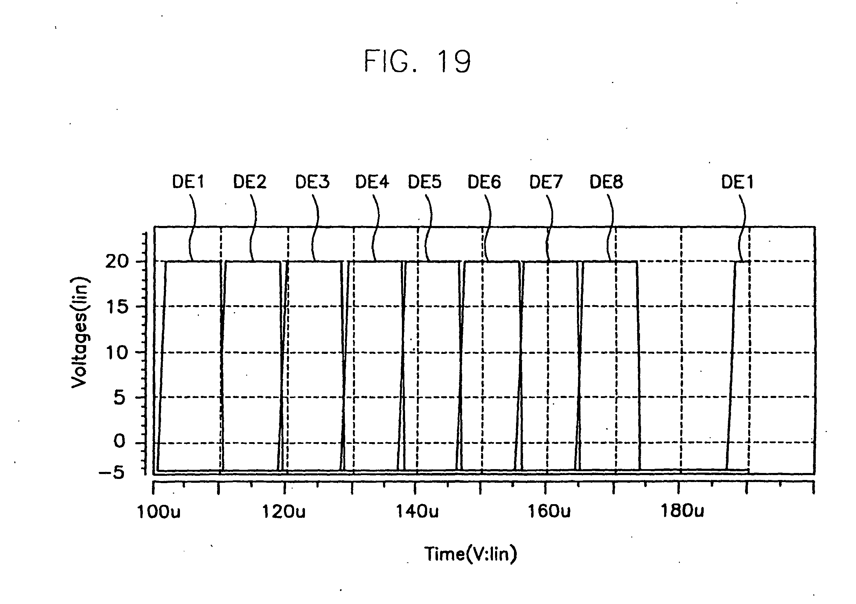

FIGS. 18 to 20 show simulation results of gate line driving signal, data line block selection signal and pixel charge characteristic when a switching transistor (SWT) is designed to have a width of 4,000 µm and a length of 5 µs and a voltage of 20 V is applied. Here, an active period of the gate line driving signal OUTi is 86 µs and an active period of the data line block signal DEi is 10 µs.

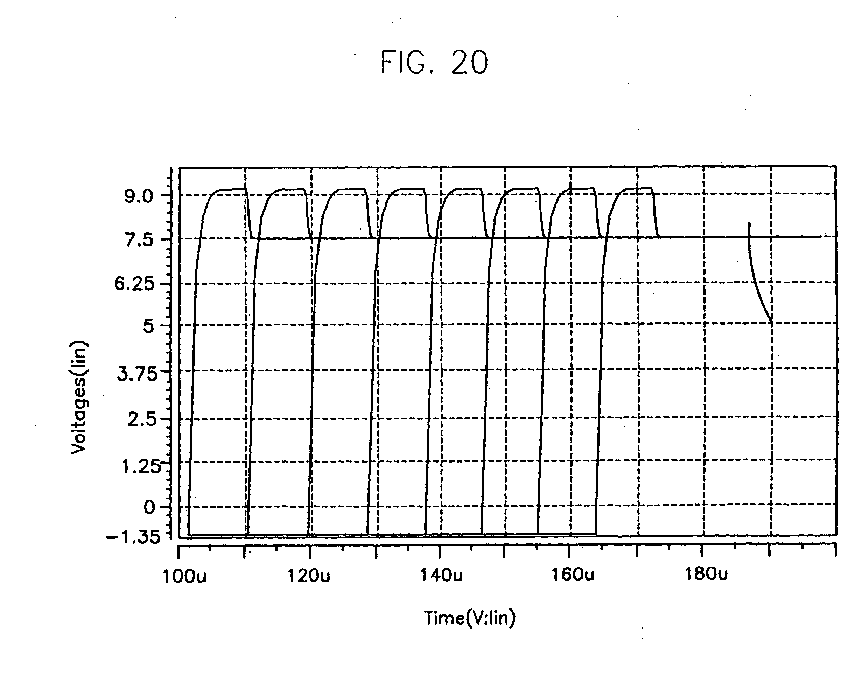

As shown in FIG. 20, the simulation result shows that the pixel charge rate of the block operation is 99% or more.

The aforementioned embodiments show and describe that the shift register of the present invention is employed in both of the data driving circuit and the gate driving circuit. It is evident, however, that a modifications and variation in which the shift register of the present invention is employed in either the data driving circuit or the gate driving circuit will be apparent to those having skills in the art in light of the foregoing description.

As described above, the present invention uses two clock signals at a shift register mounted on the glass substrate of an LCD panel, so that it is possible to decrease the number of external connection terminals. Also, the second power voltage is continuously supplied to prevent the gate of the pull-down transistor from being floated in a disable state, so that it is possible to perform a stable operation regardless of the fluctuation in the threshold voltage of a-Si TFT LCD on a use of a long-term.

Moreover, the present invention employs the block driving manner using the shift register in a small sized amorphous silicon TFT panel such as a 2" panel, so that the number of the connection channels decreases markedly.

This invention has been described above with reference to the aforementioned embodiments. It is evident, however, that many alternative modifications and variations will be apparent to those having skills in the art in light of the foregoing description. Accordingly, the present invention embraces all such alternative modifications and variations as fall within the scope of the appended claims.

## Claims

1. A shift register (174) in which plural stages are connected one after another to each other, the plural stages having a first stage in which a start signal is coupled to an input terminal (IN) the shift register sequentially outputting output signals (OUT) of respective stages, each of the plural stages having:
a pull-up means (180) for providing a clock signal (CK) to an output terminal;
a pull-up driving means (184) connected to an input node (N1) of the pull-up means, for turning on the pull-up means in response to a front edge of an input signal (IN) and turning off the pull-up means in response to a front edge of an output signal of a next stage (CT);
a pull-down means (182) for providing a first power voltage (VSS) to the output terminal; and
a pull-down driving means (186) connected to an input node (N2) of the pull-down means, for turning off the pull-down means in response to the front edge of the input signal applied to the input node of the pull-up means and turning on the pull-down means in response to the front edge of the output signal of the next stage applied to turn-off the pull-up means,
wherein the plural stages of the shift register include odd numbered stages for receiving a first clock signal (CK,CKH) and even numbered stages for receiving a second clock signal (CKB, CKBH) having a phase opposite to that of the first clock signal, and the pull-up means of each odd and even stage receives a respective one of the first and second clock signals and provides a corresponding one of the first and second clock signals to the output terminal.

2. The shift register of claim 1, wherein each of the plural stages further comprises a floating preventing means (188) connected to the input node (N2) of the pull-down means, wherein the floating preventing means provides a second power voltage (VDD) to the input node of the pull-down means to prevent the input node of the pull-down means from being floated.

3. The shift register of claim 2, wherein each of the plural stages further comprises a turn-on preventing means (190) connected to the input node of the pull-down means, wherein the turn-on preventing means provides the first power voltage to the input node of the pull-down means in response to the output signal of the output terminal to prevent the pull-down means from being turned on.

4. The shift register of claim 3, wherein the turn on preventing means comprises an NMOS transistor (NT8) of which drain is connected to the input node of the pull-down means, gate is connected to the output terminal and source is connected to the first power voltage.

5. The shift register of claim 2, wherein the pull-up driving means comprises:
a capacitor (c) connected between the input node (N1) of the pull-up means and the output terminal (OUT);
a first transistor (NT3) of which drain and gate are commonly connected to the input terminal (IN) and source is connected to the input node (N1) of the pull-up means;
a second transistor (NT4) of which drain is connected to the input node of the pull-up means (N1), gate is connected to the input node of the pull-down means (N2) and source is connected to the first power voltage (VSS); and
a third transistor (NT5) of which drain is connected to the input node of the pull-up means (N1), gate is connected to the output terminal of the next stage (CK) and source is connected to the first power voltage (VSS).

6. The shift register of claim 5, wherein the pull-down driving means comprises:
a fourth transistor (NT6) of which drain is connected to the second power voltage (VDD), gate is connected to the output terminal of the next stage (CK) and source is connected to the input node (N2) of the pull-down means; and
a fifth transistor (NT7) of which drain is connected to the input node (N1) of the pull-down means, gate is connected to the input terminal and source is connected to the first power voltage (VSS).

7. The shift register of claim 6, wherein the floating preventing means comprises a sixth transistor (NT8) of which drain and gate are connected to the second power voltage (VDD) and source is connected to the input node (N2) of the pull-down means, wherein the sixth transistor has a size smaller sufficiently than the fifth transistor.

8. The shift register of claim 7, wherein a size ratio of the fifth transistor to the sixth transistor is approximately 20:1.

9. An LCD comprising a display cell array circuit, a data driving circuit (160) and a gate driving circuit (170) formed on a transparent substrate (112a), the display cell array circuit comprising plural data lines (DL) and plural gate lines (GL), each of the display cell arrays connected to a corresponding pair of data line and gate line,
the gate driving circuit comprising the shift register of claim 1 and; the shift register further comprising
a floating preventing means (188) connected between the input node of the pull-down means (N2) and a second power voltage (VDD), for always connecting the second power voltage to the input node of the pull-down means to prevent the input node of the pull-down means from being floated. power voltage.

10. The LCD of claim 9, further comprising an external connection terminal (172) having five terminals of a first clock signal input terminal, a second clock signal input terminal, a start signal input terminal, a first power voltage input terminal and a second power voltage input terminal.

11. The LCD of claim 9, wherein each of the display cell array circuit (150), the data driving circuit (160) and the gate driving circuit (170) is of a NMOS transistor made of amorphous silicon TFT.

12. An LCD comprising a display cell array circuit, a data driving circuit (160) and a gate driving circuit (170) formed on a transparent substrate, the display cell array circuit comprising plural data lines (DL) and plural gate lines (GL), each of the display cell arrays connected to a corresponding pair of data line and gate line,
wherein the data driving circuit comprises plural data line blocks (BL1-BL8) and the shift register of claim 1,
wherein each of the data line blocks comprises plural driving transistors each of which drain and source are respectively connected between a data input terminal and the data line and gate is commonly connected to a block selection terminal, power voltage.

13. The LCD of claim 12, further comprising an external connection terminal (172) having a first clock signal input terminal, a second clock signal input terminal, a block selection start signal input terminal and plural data input terminals.

14. The LCD of claim 12, wherein each of the display cell array circuit (150), the data driving circuit (160) and the gate driving circuit (170) comprises a NMOS transistor made of amorphous silicon TFT.

15. An LCD having an LCD module in which a liquid crystal is interposed between a lower transparent substrate (112a) and an upper transparent substrate (112b) the LCD comprising:
a display cell array circuit (150) formed on the lower transparent substrate, comprising plural data lines and plural gate lines, each of the display cell arrays connected to a corresponding pair of data line and gate line,
a gate driving circuit (170) formed on the lower transparent substrate and comprising a first shift register of claim 1
a data driving circuit (160) formed on the lower transparent substrate and comprising plural data line blocks and a second shift register, each of the data line blocks comprising plural driving transistors each of which drain and source are connected between a data input terminal and the data line and gate is commonly connected to a block selection terminal, the second shift register comprising plural stages connected one after another to each other, the plural stages having a first stage in which a block selection start signal is coupled to an input terminal, for sequentially selecting the plural data line blocks using an output signal of each stage; and
a flexible PCB (116) on which an integral control and data driving chip is mounted, for providing a control signal and a data signal to the input terminal of the gate and data driving circuits.

16. The LCD of claim 15, wherein a duty period of the first and second clock signals applied to the first shift register is greater than a period of a duty period of the first and second clock signals applied to the second shift register multiplied by a number of the data line blocks.

17. The LCD of claim 15, wherein the lower transparent substrate (112a) is connected to the flexible PCB (116) through an external connection terminal (118, 172), wherein the external connection terminal comprises: five terminals connected to the data driving circuit of a first clock signal input terminal, second clock signal input terminal, scan start signal input terminal, first power voltage input terminal and second power voltage input terminal; and three control terminals of first clock signal input terminal, second clock signal input terminal and block selection start signal input terminal and plural data input terminals all of which are connected to the data driving circuit.

## Patentansprüche

1. Schieberegister (174), in dem mehrere Phasen hintereinander miteinander verbunden sind, wobei die mehreren Phasen eine erste Phase aufweisen, in der ein Startsignal mit einem Eingangsanschluss (IN) gekoppelt ist, wobei das Schieberegister hintereinander Ausgangssignale (OUT) entsprechender Phasen abgibt und wobei jede der mehreren Phasen Folgendes umfasst:
ein Pull-up-Mittel (180) zur Abgabe eines Taktsignals (CK) an einen Ausgangsanschluss;
ein Pull-up-Steuermittel (184), das an einen Eingangsknoten (N1) des Pull-up-Mittels angeschlossen ist, um das Pull-up-Mittel in Reaktion auf eine Vorderflanke eines Eingangssignals (IN) einzuschalten und das Pull-up-Mittel in Reaktion auf eine Vorderflanke eines Ausgangssignals einer nächsten Phase (CT) auszuschalten;
ein Pull-down-Mittel (182) zum Anlegen einer ersten Stromspannung (VSS) an den Ausgangsanschluss; und
ein Pull-down-Steuermittel (186), das an einen Eingangsknoten (N2) des Pull-down-Mittels verbunden ist, um das Pull-down-Mittel in Reaktion auf die Vorderflanke des an den Eingangsknoten des Pull-up-Mittels angelegten Eingangssignals auszuschalten und das Pull-down-Mittel in Reaktion auf die Vorderflanke des zum Ausschalten des Pull-up-Mittels angelegten Ausgangssignals der nächsten Phase einzuschalten,
wobei die mehreren Phasen des Schieberegisters ungerade nummerierte Phasen zum Empfangen eines ersten Taktsignals (CK, CKH) und gerade nummerierte Phasen zum Empfangen eines zweiten Taktsignals (CKB, CKBH) umfassen, die eine Phase entgegengesetzt jener des ersten Taktsignals aufweisen, und wobei das Pull-up-Mittel jeder ungeraden und geraden Phase ein entsprechendes der ersten und zweiten Taktsignale empfängt und ein entsprechendes der ersten und zweiten Taktsignale an den Ausgangsabschluss abgibt.

2. Schieberegister gemäß Anspruch 1, wobei jede der mehreren Phasen ferner ein an den Eingangsknoten (N2) des Pull-down-Mittels angeschlossenes Floating-Verhinderungsmittel (188) umfasst, wobei das Floating-Verhinderungsmittel eine zweite Stromspannung (VDD) an den Eingangsknoten des Pull-down-Mittels anlegt, um das Floaten des Eingangsknotens des Pull-down-Mittels zu verhindern.

3. Schieberegister gemäß Anspruch 2, wobei jede der mehreren Phasen ferner ein an den Eingangsknoten des Pull-down-Mittels angeschlossenes Einschaltverhinderungsmittel (190) umfasst, wobei das Einschaltverhinderungsmittel die erste Stromspannung an den Eingangsknoten des Pull-down-Mlttels in Reaktion auf das Ausgangssignal des Ausgangsanschlusses anlegt, um das Einschalten des Pull-down-Mittels zu verhindern.

4. Schieberegister gemäß Anspruch 3, wobei das Einschaltverhinderungsmittel einen NMOS-Transistor (NT8) umfasst, dessen Drain an den Eingangsknoten des Pull-down-Mittels angeschlossen ist, dessen Gate an den Ausgangsanschluss und dessen Source an die erste Stromspannung angeschlossen ist.

5. Schieberegister gemäß Anspruch 2, wobei das Pull-up-Steuermittel Folgendes umfasst:
einen Kondensator (c), der zwischen dem Eingangsknoten (N1) des Pull-up-Mlttels und dem Ausgangsanschluss (OUT) angeschlossen ist;
einen ersten Transistor (NT3), dessen Drain und Gate gemeinsam am Eingangseinschluss (IN) und dessen Source am Eingangsknoten (N1) des Pull-up-Mittels angeschlossen sind;
einen zweiten Transistor (NT4), dessen Drain an den Eingangsknoten des Pull-up-Mittels (N1) angeschlossen ist, dessen Gate an den Eingangsknoten des Pull-down-Mittels (N2) und dessen Source an die erste Stromspannung (VSS) angeschlossen ist; und
einen dritten Transistor (NT5), dessen Drain an den Eingangsknoten des Pull-up-Mittels (NT1) angeschlossen ist, dessen Gate an den Ausgangsanschluss der nächsten Phase (CK) und dessen Source an die erste Stromspannung (VSS) angeschlossen ist.

6. Schieberegister gemäß Anspruch 5, wobei das Pull-down-Steuermittel Folgendes umfasst:
einen vierten Transistor (NT6), dessen Drain mit der zweiten Stromspannung (VDD), dessen Gate mit dem Ausgangsanschluss der nächsten Phase (CK) und dessen Source am Eingangsknoten (N2) des Pull-down-Mittels angeschlossen ist; und
einen fünften Transistor (NT7), dessen Drain an den Eingangsknoten (N1) des Pull-down-Mittels angeschlossen ist, dessen Gate an den Eingangsanschluss und dessen Source an die erste Stromspannung (VSS) angeschlossen ist.

7. Schieberegister gemäß Anspruch 6, wobei das Floating-Verhinderungsmittel einen sechsten Transistor (NT8) umfasst, dessen Drain und Gate an die zweite Stromspannung (VDD) und dessen Source an den Eingangsknoten (N2) des Pull-down-Mittels angeschlossen ist, wobei der sechste Transistor eine Größe aufweist, die ausreichend kleiner als der fünfte Transistor ist.

8. Schieberegister gemäß Anspruch 7, wobei ein Größenverhältnis des fünften Transistors zum sechsten Transistor annähernd 20:1 beträgt.

9. LCD, umfassend einen Display-Zellmatrix-Schaltkreis, einen Daten-Steuerschaltkreis (160) und einen Gate-Steuerschaltkreis (170), die auf einem transparentem Substrat (112a) gebildet sind, wobei der Display-Zellmatrix-Schaltkreis mehrere Datenleitungen (DL) und mehrere Gate-Leitungen (GL) umfasst, wobei jede Display-Zellmatrix an ein entsprechendes Paar aus Datenleitung und Gate-Leitung angeschlossen ist,
wobei der Gate-Steuerschaltkreis das Schieberegister gemäß Anspruch 1 umfasst und das Schieberegister ferner ein Floating-Verhinderungsmittel (188) umfasst, das zwischen dem Eingangsknoten des Pull-down-Mittels (N2) und einer zweiten Stromspannung (VDD) angeschlossen ist, um die zweite Stromspannung immer mit dem Eingangsknoten des Pull-down-Mittels zu verbinden und damit das Floaten des Eingangsknotens des Pull-down-Mittels zu verhindern.

10. LCD gemäß Anspruch 9, die ferner einen externen Verbindungsanschluss (172) umfasst, der fünf Anschlüsse eines ersten Taktsignaleingangsanschlusses, eines zweiten Taktsignaleingangsanschlusses, eines Startsignaleingangsanschlusses, eines ersten Stromspannungseingangsanschlusses und eines zweiten Stromspannungseingangsanschlusses aufweist.

11. LCD gemäß Anspruch 9, wobei der Display-Zellmatrix-Schaltkreis (150), der Daten-Steuerschaltkreis (160) und der Gate-Steuerschaltkreis (170) jeweils ein NMOS-Transistor ist, bestehend aus einem amorphen Silizium-TFT.

12. LCD mit einem Display-Zellmatrix-Schaltkreis, einem Daten-Steuerschaltkreis (160) und einem Gate-Steuerschaltkreis (170), die auf einem transparenten Substrat gebildet sind, wobei der Display-Zellmatrix-Schaltkreis mehrere Datenleitungen (DL) und mehrere Gate-Leitungen (GL) umfasst, wobei die Display-Zellmatritzen jeweils an ein entsprechendes Paar aus einer Datenleitung und Gate-Leitung angeschlossen sind,
wobei der Daten-Steuerschaltkreis mehrere Datenleitungsblöcke (BL1-BL8) und das Schieberegister gemäß Anspruch 1 umfasst,
wobei jeder der Datenleitungsblöcke mehrere Steuertransistoren umfasst, deren Drain und Source jeweils zwischen einem Dateneingangsanschluss und der Datenleitung angeschlossen sind und deren Gate-Leitung gewöhnlich an einen Blockauswahlanschluss angeschlossen ist.

13. LCD gemäß Anspruch 12, das ferner einen externen Verbindungsanschluss (172) mit einem ersten Taktsignaleingangsanschluss, einem zweiten Taktsignaleingangsanschluss, einem Blockauswahl-Startsignal-Eingangsanschluss und mehreren Dateneingangsanschlüssen umfasst.

14. LCD gemäß Anspruch 12, wobei der Display-Zellmatrix-Schaltkrels (150), der Daten-Steuerschaltkreis (160) und der Gate-Steuerschaltkreis (170) jeweils einen NMOS-Transistor umfassen, bestehend aus einem amorphen Silizium-TFT.

15. LCD mit einem LCD-Modul, in dem ein Flüssigkristall zwischen einem unteren transparenten Substrat (112a) und einem oberen transparenten Substrat (112b) eingefügt ist, wobei das LCD Folgendes umfasst:
einen auf dem unteren transparenten Substrat gebildeten Display-Zellmatrix-Schaltkreis (150), der mehrere Datenleitungen und mehrere Gate-Leitungen umfasst, wobei jede der Display-Zellmatritzen an ein entsprechendes Paar aus einer Datenleitung und einer Gate-Leitung angeschlossen ist,
einen auf dem unteren transparenten Substrat gebildeten und ein erstes Schieberegister gemäß Anspruch 1 umfassenden Gate-Steuerschaltkreis (170),
einen auf dem unteren transparenten Substrat gebildeten und mehrere Datenleitungsblöcke und ein zweites Schieberegister umfassenden Daten-Steuerschaltkreis (160), wobei jeder der Datenleitungsblöcke mehrere Steuertransistoren umfasst, deren Drain und Source jeweils zwischen einem Dateneingangsanschluss und der Datenleitung angeschlossen sind und deren Gate gewöhnlich an einen Blockauswahlanschluss angeschlossen ist, wobei das zweite Schieberegister mehrere hintereinander miteinander verbundene Phasen umfasst, wobei die mehreren Phasen eine erste Phase aufweisen, in der ein Blockauswahl-Startsignal an einen Eingangsanschluss gekoppelt ist, um unter Anwendung eines Ausgangssignals der einzelnen Phasen hintereinander die mehreren Datenleitungsblöcke auszuwählen,
ein flexibles PCB (116), auf dem ein integrierter Kontroll- und Datensteuerchip montiert ist, um ein Kontrollsignal und ein Datensignal an den Eingangsanschluss der Gate- und Daten-Steuerschaltkreise abzugeben.

16. LCD gemäß Anspruch 15, wobei eine Einschaltperiode des ersten und zweiten Taktsignals am ersten Schieberegister größer ist als eine Einschaltperiode des ersten und zweiten Taktsignals am zweiten Schieberegister, multipliziert mit einer Anzahl der Datenleitungsblöcke.

17. LCD gemäß Anspruch 15, wobei das untere transparente Substrat (112a) über einen externen Verbindungsanschluss (118, 172) an das flexible PCB (116) angeschlossen ist, wobei der externe Verbindungsanschluss Folgendes umfasst:
fünf Anschlüsse, die an den Daten-Steuerschaltkreis eines ersten Taktsignaleingangsanschlusses, eines zweiten Taktsignaleingangsanschlusses, eines Abtast-StartsignalEingangsanschlusses, eines ersten Stromspannungseingangsanschlusses und eines zweiten Stromspannungselngangsanschlusses angeschlossen sind,
und drei Kontrollanschlüsse eines ersten Taktsignaleingangsanschlusses, eines zweiten Steuersignaleingangsanschlusses und eines Blockauswahl-Startsignal-Eingangsanschlusses,
und mehrere Dateneingangsanschlüsse, die sämtlich an den Datensteuerschaltkreis angeschlossen sind.

## Revendications

1. Registre à décalage (174) dans lequel plusieurs étages sont connectés les uns aux autres à la suite les uns des autres, les multiples étages comprenant un premier étage dans lequel un signal de départ est couplé à une borne d'entrée (IN), le registre à décalage émettant successivement en sortie des signaux de sortie (OUT) d'étages correspondants, chacun des multiples étages possédant :
un moyen de pull-up (180) pour fournir un signal d'horloge (CK) à des bornes de sortie ;
un moyen de pilotage du pull-up (184) connecté à un noeud d'entrée (N1) du moyen de pull-up, destiné à activer le moyen de pull-up en réponse à un flanc avant d'un signal d'entrée (IN) et à désactiver le moyen de pull-up en réponse à un flanc avant d'un signal de sortie d'un étage suivant (CT) ;
un moyen de pull-down (182) destiné à fournir une première tension d'alimentation (VSS) à la borne de sortie ; et
un moyen de pilotage du pull-down (186) connecté à un noeud d'entrée (N2) du moyen de pull-down, pour désactiver le moyen de pull-down en réponse au flanc avant du signal d'entrée appliqué au noeud d'entrée du moyen de pull-up et activer le moyen de pull-down en réponse au flanc avant du signal de sortie de l'étage suivant appliqué pour désactiver le moyen de pull-up,
dans lequel les multiples étages du registre à décalage comprennent des étages à numérotation impaire destinés à recevoir un premier signal d'horloge (CK, CKH) et des étages à numérotation paire destinés à recevoir un deuxième signal d'horloge (CKB, CKBH) ayant une phase opposée à celle du premier signal d'horloge, et le moyen de pull-up de chaque étage à numérotation impaire reçoit l'un des premiers et deuxièmes signaux d'horloge respectif et fournit l'un des premiers et deuxièmes signaux d'horloges correspondant à la borne de sortie.

2. Registre à décalage selon la revendication 1, dans lequel chacun des multiples étages comprend en outre un moyen de prévention du flottement (188) connecté au noeud d'entrée (N2) du moyen de pull-down, lequel moyen de prévention du flottement fournit une deuxième tension d'alimentation (VDD) au noeud d'entrée du moyen de pull-down pour empêcher le flottement du noeud d'entrée du moyen de pull-down.

3. Registre à décalage selon la revendication 2, dans lequel chacun des multiples étages comprend en outre un moyen de prévention de l'activation (190) connecté au noeud d'entrée du moyen de pull-down, lequel moyen de prévention de l'activation fournit la première tension d'alimentation au noeud d'entrée du moyen de pull-down en réponse au signal de sortie de la borne de sortie afin d'empêcher l'activation du moyen de pull-down.

4. Registre à décalage selon la revendication 3, dans lequel le moyen de prévention de l'activation comprend un transistor NMOS (NT8) dont le drain est connecté au noeud d'entrée du moyen de pull-down, la grille est connectée à la borne de sortie et la source est connectée à la première tension d'alimentation.

5. Registre à décalage selon la revendication 2, dans lequel le moyen de pilotage du pull-up comprend :
une capacité (C) montée entre le noeud d'entrée (N1) du moyen de pull-up et la borne de sortie (OUT) ;
un premier transistor (NT3) dont le drain et la grille sont montés ensemble sur la borne d'entrée (IN) et la source est connectée au noeud d'entrée (N1) du moyen de pull-up ;
un deuxième transistor (NT4) dont le drain est connecté au noeud d'entrée du moyen de pull-up (N1), la grille est connectée au noeud d'entrée du moyen de pull-down (N2) et la source est connectée à la première tension d'alimentation (VSS) ; et
un troisième transistor (NT5) dont le drain est connecté au noeud d'entrée
du moyen de pull-up (N1), la grille est connectée à la borne de sortie de l'étage suivant (CK) et la source est connectée à la première tension d'alimentation (VSS).

6. Registre à décalage selon la revendication 5, dans lequel le moyen de pilotage du pull-down comprend :
un quatrième transistor (NT6) dont le drain est connecté à la deuxième tension d'alimentation (VDD), la grille est connectée à la borne de sortie de l'étage suivant (CK) et la source est connectée au noeud d'entrée (N2) du moyen de pull-down ; et
un cinquième transistor (NT7) dont le drain est connecté au noeud d'entrée (N2) du moyen de pull-down, la grille est connectée à la borne d'entrée et la source est connectée à la première tension d'alimentation (VSS).

7. Registre à décalage selon la revendication 6, dans lequel le moyen de prévention du flottement comprend un sixième transistor (NT8) dont le drain et la grille sont connectés à la deuxième tension d'alimentation (VDD) et la source est connectée au noeud d'entrée (N2) du moyen de pull-down, le sixième transistor ayant une taille suffisamment plus petite que le cinquième transistor.

8. Registre à décalage selon la revendication 7, dans lequel un rapport de taille entre le cinquième transistor et le sixième transistor est d'environ 20:1.

9. Afficheur à cristaux liquides comprenant un circuit de matrice de cellules d'affichage, un circuit de pilotage de données (160) et un circuit de pilotage de grille (170) formés sur un substrat transparent (112a), le circuit de matrice de cellules d'affichage comprenant plusieurs lignes de données (DL) et plusieurs lignes de grille (GL), chacune des matrices de cellules d'affichage étant connectée à une paire correspondante d'une ligne de données et d'une ligne de grille,
le circuit de pilotage de ligne comprenant le registre à décalage selon la revendication 1, et le registre à décalage comprenant en outre :
un moyen de prévention du flottement (188) monté entre le noeud d'entrée du moyen de pull-down (N2) et une deuxième tension d'alimentation (VDD) pour connecter toujours la deuxième tension d'alimentation au noeud d'entrée du moyen de pull-down afin d'empêcher le flottement du noeud d'entrée du moyen de pull-down.

10. Afficheur à cristaux liquides selon la revendication 9, comprenant en outre une borne de connexion externe (172) comportant cinq bornes pour une première borne d'entrée de signal d'horloge, une deuxième borne d'entrée de signal d'horloge, une borne d'entrée de signal de démarrage, une première borne d'entrée de tension d'alimentation et une deuxième borne d'entrée de tension d'alimentation.

11. Afficheur à cristaux liquides selon la revendication 9, dans lequel le circuit de matrice de cellules d'affichage (150), le circuit de pilotage de données (160) et le circuit de pilotage de grille (170) sont chacun composés d'un transistor NMOS fait d'un TFT en silicium amorphe.

12. Afficheur à cristaux liquides comprenant un circuit de matrice de cellules d'affichage, un circuit de pilotage de données (160) et un circuit de pilotage de grille (170) formés sur un substrat transparent, le circuit de matrice de cellules d'affichages comprenant plusieurs lignes de données (DL) et plusieurs lignes de grille (GL), chacune des matrices de cellules d'affichage étant connectée à une paire correspondante d'une ligne de données et une ligne de grille,
dans lequel le circuit de pilotage de données comprend plusieurs blocs de lignes de données (BL1-BL8) et le registre à décalage selon la revendication 1,
dans lequel chacun des blocs de lignes de données comprend plusieurs transistors de pilotage dont le drain et la source de chacun sont connectés respectivement entre une borne d'entrée de données et la ligne de données et la grille est connectée conjointement à une borne de sélection de bloc.

13. Afficheur à cristaux liquides selon la revendication 12, comprenant en outre une borne de connexion externe (172) possédant une première borne d'entrée de signal d'horloge, une deuxième borne d'entrée de signal d'horloge, une borne d'entrée de signal de début de sélection de bloc et plusieurs bornes d'entrée de données.

14. Afficheur à cristaux liquides selon la revendication 12, dans lequel le circuit de matrice de cellules d'affichage (150), le circuit de pilotage de données (160) et le circuit de pilotage de grille (170) comprennent chacun un transistor NMOS fait d'un TFT en silicium amorphe.

15. Afficheur à cristaux liquides comprenant un module d'affichage à cristaux liquides dans lequel un cristal liquide est intercalé entre un substrat transparent inférieur (112a) et un substrat transparent supérieur (112b), lequel afficheur à cristaux liquides comprend :
un circuit de matrice de cellules d'affichage (150) formé sur le substrat
transparent inférieur, comprenant plusieurs lignes de données et plusieurs lignes de grille, chacune des matrices de cellules d'affichage étant connectée à une paire correspondante d'une ligne de données et une ligne de grille,
un circuit de pilotage de grille (170) formé sur le substrat transparent inférieur, et comprenant un premier registre à décalage selon la revendication 1,
un circuit de pilotage de données (160) formé sur le substrat transparent inférieur et comprenant plusieurs blocs de lignes de données et un deuxième registre à décalage, chacun des blocs de lignes de données comprenant plusieurs transistors de pilotage dont le drain et la source de chacun sont connectés entre une borne d'entrée de données et la ligne de données et la grille est connectée conjointement à une borne de sélection de bloc, le deuxième registre à décalage comprenant plusieurs étages connectés les uns aux autres les uns à la suite des autres, les multiples
étages comprenant un premier étage dans lequel un signal de début de sélection de bloc est couplé à une borne d'entrée pour une sélection successive des multiples blocs de lignes de données à l'aide d'un signal de sortie de chaque étage ; et
une carte de circuits imprimés flexible (116) sur laquelle est montée une puce intégrée de commande et de pilotage de données, destinée à fournir un signal de contrôle et un signal de données à la borne d'entrée des circuits de pilotage de grille et de données.

16. Afficheur à cristaux liquides selon la revendication 15, dans lequel une période de service des premier et deuxième signaux d'horloge appliqués au premier registre à décalage est plus longue qu'une période de service des premier et deuxième signaux d'horloge appliqués au deuxième registre à décalage multipliée par le nombre des blocs de lignes de données.

17. Afficheur à cristaux liquides selon la revendication 15, dans lequel le substrat transparent inférieur (112a) est connecté à la carte de circuits imprimés flexible (116) par l'Intermédiaire d'une borne de connexion externe (118, 172), la borne de connexion externe comprenant cinq bornes connectées au circuit de pilotage de données pour une première borne d'entrée de signal d'horloge, une deuxième borne d'entrée de signal d'horloge, une borne d'entrée de signal de démarrage de balayage, une première borne d'entrée de tension d'alimentation et une deuxième borne d'entrée de tension d'alimentation ; et trois bornes de contrôle pour la première borne d'entrée de signal d'horloge, la deuxième borne d'entrée de signal d'horloge et la borne d'entrée de signal de début de sélection de bloc et plusieurs bornes d'entrée de données qui sont toutes connectées au circuit de pilotage de données.
